# FASCICULE DE BREVET EUROPEEN

(11) **EP 0 321 029 B1**
(45) Date de publication et mention de la délivrance du brevet: **17.03.1993**
(21) Numéro de dépôt: 88202822.8
(22) Date de dépôt: 09.12.1988
(51) Int. Cl.: G03F 7/20, G03F 9/00

(54) **Procédé d'obtention de motifs alignés entre eux sur deux faces opposées d'une plaque opaque**
Verfahren zur Ausrichtung von Bildern auf die beiden Seiten eines lichtundurchlässigen Trägers
Process for obtaining aligned patterns on opposite sides of an opaque support

(30) Priorité: 15.12.1987 FR 8717477
(43) Date de publication de la demande: 21.06.1989
(73) Titulaire: PHILIPS COMPOSANTS, 92130 Issy les Moulineaux (FR); Philips Electronics N.V., 5621 BA Eindhoven (NL)
(72) Inventeur: Goirand, Pierre Société Civile S.P.I.D., F-75007 Paris (FR); Schneider, Jacques Société Civile S.P.I.D., F-75007 Paris (FR)
(74) Mandataire: Charpail, François

(56) Documents cités:
- DE-B- 1 060 717

## Description

La présente invention a pour objet un procédé d'obtention de motifs alignés entre eux sur une première et une deuxième faces opposées d'une plaque opaque présentant sur la première face au moins un motif de repérage.

Une technique déjà connue pour réaliser un tel alignement met en oeuvre une machine spécifique avec laquelle deux masques sont alignés l'un part rapport à l'autre, la plaque étant disposée entre les deux masques et alignée par rapport à l'un d'eux.

Cette technique nécessite la mise en oeuvre d'un équipement coûteux car, d'une part, il est spécifique et, d'autre part, il est compliqué la machine devant réaliser un alignement double face. En outre, sa précision n'est pas vraiment excellente (de l'ordre de ± 5 microns).

L'invention à pour objet un procédé selon lequel une machine simple face, non spécifique, peut être utilisée, avec une précision au moins égale à celle de l'art antérieur.

L'idée de base de l'invention consiste à coller la plaque opaque sur une lame transparente, du côté des motifs déjà existants, et de reporter par photolithographie sur la lame transparente des motifs alignés par rapport aux motifs existants. Ces motifs de la lame de verre servent à leur tour de repérage pour réaliser les motifs désirés sur l'autre face de la plaque opaque.

Dans ce but, le procédé selon l'invention est tel que défini dans la partie caractérisante de la revendication 1.

La plaque opaque peut être un cristal semi-conducteur, et la lame transparente peut être en verre.

La solidarisation de la plaque opaque et de la lame transparente peut être réalisée à l'aide d'une cire transparente.

Dans le cas particulier où le troisième motif d'alignement est symétrique de telle manière qu'il se retrouve semblable à lui-même par retournement, le masque d'alignement et le masque de réalignement sont avantageusement identiques.

Selon un mode de réalisation préféré permettant d'obtenir une très bonne précision d'alignement, les opérations d'alignement et d'insolation sont réalisées à l'aide d'un appareillage simple face travaillant en projection.

L'invention sera mieux comprise à la lecture de la description qui va suivre donnée à titre d'exemple non limitatif, en liaison avec les dessins qui représentent :
- les figures 1a à 1h, les étapes du procédé selon l'invention
- la figure 2, un appareillage d'alignement par projection, connu en soi, tel qu'il peut être utilisé pour mettre en oeuvre le procédé selon l'invention.

Selon la figure 1a, une plaque opaque 2, notamment un cristalsemiconducteur comportant par exemple des diodes électroluminescentes, présente sur une face dite inférieure un motif de repérage 3 et éventuellement un motif de liaisons conductrices 7. Les motifs 3 et 7 peuvent être en matériaux conducteurs, par exemple sous forme de bandes ou de plots métalliques.

La plaque opaque 2 est collée sur la partie centrale de la face dite supérieure d'une lame transparente 1 de plus grande dimensions que la plaque 2, de manière que la lame transparente 1 déborde en s du contour de la plaque 2. Le collage est réalisé à l'aide d'une couche transparente de colle 4 permettant la désolidarisation ultérieure de la plaque 2 et de la lame 1, par exemple une cire transparente.

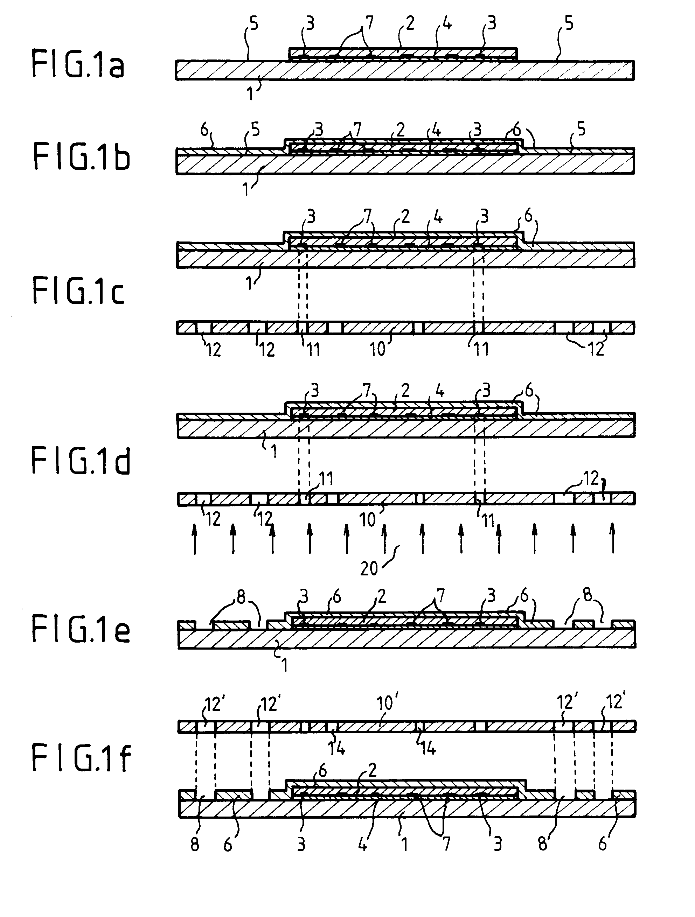

Selon la figure 1b, une couche de photorésist positif 6 est déposée sur la partie en débord 5 de la face supérieure de la lame 1 et sur la face supérieure de la plaque 2.

Selon la figure 1c, un masque d'alignement 10 est positionné par rapport au motif de repérage 3. Ce positionnement est effectué en alignant optiquement des ouvertures d'alignement 11 du masque avec le motif de repérage 3. Le masque d'alignement 10 comporte également des ouvertures 12 en regard de la partie débordante de la lame 1.

Selon la figure 1d, on insole le masque 10 à l'aide d'un rayonnement 20 susceptible d'induire une transformation chimique du photorésist 6, de manière à générer un motif d'alignement correspondant aux ouvertures 12. Cette insolation étant effectuée par la face inférieure de la lame 1, la plaque opaque 2 protège le photorésist 6 qui recouvre sa face supérieure.

Selon la figure 1e, on révèle le photorésist 6, de manière à faire apparaître des ouvertures 8 ayant le contour du motif d'alignement.

Selon la figure 1f, on aligne avec les ouvertures 9, les ouvertures 12' d'un masque de réalignement 10' disposé du côté de la face supérieure, de la lame 1 et de la plaque 2. Le masque de réalignement 10' comporte également des ouvertures 14 correspondant à un motif fonctionnel à réaliser sur la face supérieure de la plaque opaque 2.

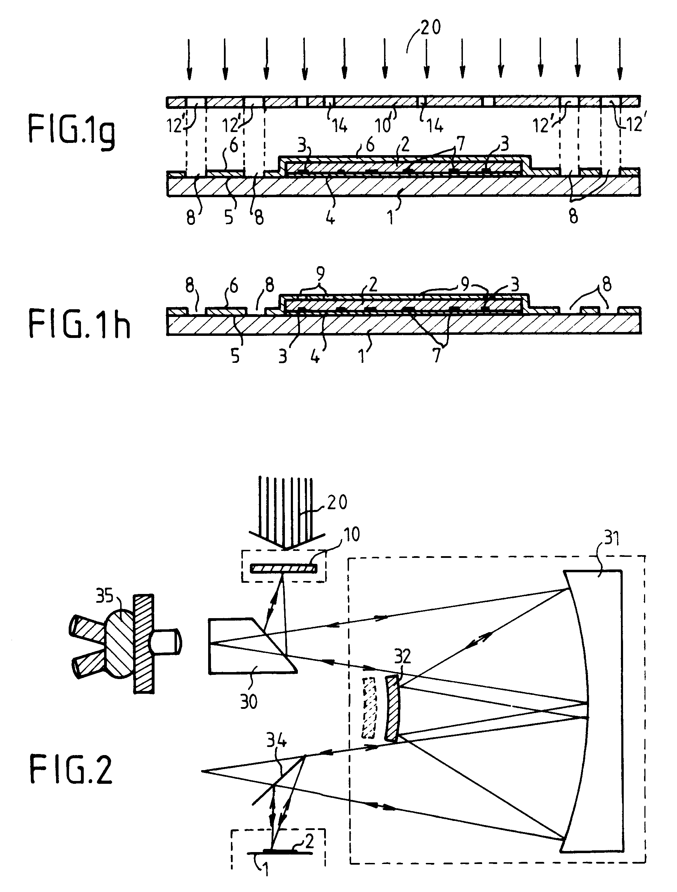

Selon la figure 1g, on insole par la face supérieure de la plaque 2 à l'aide du rayonnement 20 de manière à générer le motif fonctionnel désiré sur le photorésist 6 qui recouvre la face supérieure de la plaque 2.

Selon la figure 1h, on révèle le photorésist de manière à faire apparaître des ouvertures 9 correspondant au motif fonctionnel désiré.

Ultérieurement, il est possible de réaliser d'autres opérations sur la plaque 2 de manière à mettre à profit les ouvertures 9 du motif fonctionnel, avant ou après désolidarisation de la plaque opaque 2 et de la lame transparente 1.

Il est particulièrement avantageux de choisir un motif d'alignement symétrique, de manière à ce qu'il se retrouve semblable à lui-même par retournement. Dans ce cas en effet, il est possible d'utiliser un seul masque faisant fonction de masque d'alignement et de réalignement. Ce masque comporte les ouvertures 14 servent à réaliser les ouvertures 9 du photorésist 6 (Fig. 1g et 1h).

L'existence de ces ouvertures 14 du masque ne présente pas d'inconvénient étant donné que lors de l'étape d (Fig. 1d), le fait que la plaque 2 soit opaque empêche toute insolation de sa face supérieure.

Selon la figure 2, un appareil simple face travaillant en projection, par exemple commercialisé sous la référence MICROALIGN III par la firme PERKIN-ELMER, comporte un miroir plan dichroïque séparant les rayons ultra-violets utilisés pour l'insolation et le rayonnement visible utilisé pour la visualisation de l'alignement du masque et de la plaque.

Le système de protection comporte également un miroir sphérique convexe 31 constituant un miroir primaire, un miroir sphérique concave 32 coaxial au premier et déplaçable le long dudit axe et un miroir plan 34 disposé de manière à être symétrique du plan du miroir 3 par rapport audit axe.

Le rayonnement 20 insole le masque 10 dont l'image est projetée sur la plaque 2 et la lame 1 par successivement le miroir plan 30, les miroirs sphériques 31 et 32 et le miroir plan 34, alors que l'alignement, réalisé par déplacement axial du miroir 32, est contrôlé par un binoculaire 35 à travers le miroir dichroïque 30.

L'appareil mentionné ci-dessus a permis d'obtenir une précision d'alignement de l'ordre de ± 2 microns.

## Revendications

1. Procédé d'obtention de motifs alignés entre eux sur une première et une deuxième faces opposées d'une plaque opaque présentant sur la première face au moins un motif de repérage caractérisé en ce qu'il comporte les étapes suivantes :
a) solidariser la première face de la plaque opaque (2) avec une première face d'une lame transparente (1) de plus grande dimension que la plaque opaque (2)
b) disposer une couche de photorésist (6) sur la deuxième face de la plaque (2) et sur la portion (5) de la première face de la lame transparente (1) qui déborde du contour de la plaque opaque,
c) aligner par rapport au motif de repérage (3), un premier motif d'alignement (11) correspondant au motif de repérage (3) et faisant partie d'un masque d'alignement (10), le masque d'alignement (10) présentant également un deuxième motif d'alignement (12) débordant du contour de la plaque opaque (2),
d) insoler (20) à travers le masque d'alignement (10) et la deuxième face de la lame transparente (1) opposée à sa première face de manière à générer un troisième motif d'alignement (8) sur le pliotorésist (6) débordant du contour de la plaque opaque (2), et correspondant audit deuxième motif d'alignement (12),
e) révéler le photorésist insolé lors de l'étape d de manière à faire apparaître le troisième motif d'alignement (8),
f) aligner un motif de réalignement (12') correspondant au troisième motif d'alignement (8) et faisant partie d'un masque de réalignement (10') disposé en regard de la deuxième face de la plaque (2), avec ledit troisième motif d'alignement (8), le masque de réalignement (10') présentant un premier motif fonctionnel (14),
g) insoler à travers le masque de réalignement (10') de manière à générer sur le photorésist (6) recouvrant la deuxième face de la plaque (2) un deuxième motif fonctionnel (9) identique au premier motif fonctionnel (14) et aligné par rapport au motif de repérage,
h) révéler le photorésist insolé lors de l'étape g, de manière à faire apparaître le deuxième motif fonctionnel (9).

2. Procédé selon la revendication 1 caractérisé en ce que la plaque opaque (2) est un cristal semi-conducteur.

3. Procédé selon une des revendications 1 et 2 caractérisé en ce que la lame transparente (1) est en verre.

4. Procédé selon une des revendications précédentes caractérisé en ce que la solidarisation de la plaque opaque (2) et de la lame transparente est réalisée à l'aide d'une couche de cire transparente (4).

5. Procédé selon une des revendications précédentes caractérisé en ce que les opérations d'alignement et d'insolation sont réalisées à l'aide d'un appareillage simple face travaillant en projection.

6. Procédé selon une des revendications précédentes caractérisé en ce que le troisième motif d'alignement (8) est symétrique de manière qu'il se retrouve semblable à lui-même par retournement et en ce que le masque d'alignement (10) et le masque de réalignement (10') sont identiques.

## Claims

1. A process for obtaining mutually aligned patterns on first and second opposite surfaces of an opaque slice having on the first surface at least one reference pattern, characterized in that it comprises the following steps:
a) joining the first surface of the opaque slice (2) to a first surface of a transparent plate (1) having larger dimensions than the opaque slice (2);
b) providing a photoresist layer (6) on the second surface of the slice (2) and on the portion (5) of the first surface of the transparent plate (1) which projects beyond the outline of the opaque slice;
c. aligning a first alignment pattern (11) corresponding to the reference pattern (3) and forming part of an alignment mask (10) with respect to the reference pattern (3), the alignment mask (10) also having a second alignment pattern (12) projecting beyond the outline of the opaque slice (2);
d) passing radiation (20) through the alignment mask (10) and the second surface of the transparent plate (1) opposite to its first surface so as to generate a third alignment pattern (8) on the photoresist (6) projecting byond the outline of the opaque slice (2) and corresponding to the said second alignment pattern (12);
e) developing the photoresist exposed during the step d) so as to cause the third alignment pattern (8) to appear;
f) aligning a realignment pattern (12') corresponding to the third alignment pattern (8) and forming part of a realignment mask (10') arranged opposite to the second surface of the slice (2) with the said third alignment pattern (8), the realignment mask (10') having a first functional pattern (14);
g) passing radiation through the realignment mask (10') so as to generate on the photoresist (6) covering the second surface of the slice (2) a second functional pattern (9) identical to the first functional pattern (14) and aligned with respect to the reference pattern;
h) developing the photoresist exposed during the step g) so as to cause the second functional pattern (9) to appear.

2. A process as claimed in Claim 1, characterized in that the opaque slice (2) is a semiconductor crystal.

3. A process as claimed in any one of Claims 1 and 2, characterized in that the transparent plate (1) consists of glass.

4. A process as claimed in any one of the preceding Claims, characterized in that the opaque slice (2) and the transparent plate are joined together by means of a layer (4) of transparent wax.

5. A process as claimed in any one of the preceding Claims, characterized in that the steps of alignment and exposure are carried out by means of a single-face apparatus operating in projection.

6. A process as claimed in any one of the preceding Claims, characterized in that the third alignment pattern (8) is symmetrical in the sense that it is similar to itself when turned over, and in that the alignment mask (10) and the realignment mask (10') are identical.

## Patentansprüche

1. Verfahren zum Erhalten zueinander ausgerichteter Strukturen auf einer ersten und einer zweiten von gegenüber liegenden Flächen einer lichtundurchlässigen Scheibe, die auf der einen Fläche mindestens eine Markierungsstruktur aufweist dadurch gekennzeichnet, daß es die folgenden Schritte enthält:
a) Verbinden der ersten Fläche der lichtundurchlässigen Scheibe (2) mit einer ersten Fläche eines transparenten Streifens (1), der viel größere Abmessungen als die lichtundurchlässige Scheibe (2) hat,
b) Aufbringen einer Photolackschicht (6) auf die zweite Fläche der Scheibe (2) und auf den Teil (5) der ersten Fläche des transparenten Streifens (1), der über den Umfang der lichtundurchlässigen Scheibe hinausreicht,
c) Ausrichten eines ersten, der Markierungsstruktur entsprechenden und zu einer Justiermaske (10) gehörenden Justiermusters (11) in bezug auf die Markierungsstruktur (3), wobei die Justiermaske (10) zugleich ein zweites Justiermuster (12) aufweist, das über den Umfang der lichtundurchlässigen Scheibe (2) hinausreicht,
d) Belichtung (20) durch die Justiermaske (10) hindurch und durch die zweite, gegenüber seiner ersten Fläche gelegene Fläche des transparenten Streifens (1) zum Erzeugen eines dritten Justiermusters (8) auf der über den Umfang der lichtundurchlässigen Scheibe (2) hinausreichenden Photolackschicht (6), das dem genannten zweiten Justiermuster (12) entspricht,
e) Entwickeln der in Schritt d) der Strahlung ausgesetzten Photolackschicht, um das dritte Justiermuster (8) erscheinen zu lassen,
f) Ausrichten eines Musters zur Nachjustierung (12'), das dem dritten Justiermuster (8) entspricht und zu einer der zweiten Fläche der Scheibe (2) gegenüberliegend angebrachten Nachjustiermaske (10') gehört, zum dritten Justiermuster (8), wobei die Nachjustiermaske (10') eine erste Funktionsstruktur (14) aufweist.
g) Belichtung durch die Nachjustiermaske (10') hindurch, um auf der die zweite Fläche der Scheibe (2) bedeckenden Photolackschicht (6) eine zweite Funktionsstruktur (9) zu erzeugen, die der ersten Funktionsstruktur (14) identisch und bezüglich der Markierungsstruktur ausgerichtet ist,
h) Entwickeln der in Schritt g) der Strahlung ausgesetzten Photolackschicht, um eine zweite Funktionsstruktur (9) erscheinen zu lassen.

2. Verfahren nach Anspruch 1, dadurch gekennzeichnet, daß die lichtundurchlässige Scheibe (2) ein Halbleiterkristall ist.

3. Verfahren nach einem der Ansprüche 1 und 2, dadurch gekennzeichnet, daß der transparente Streifen (1) aus Glas ist.

4. Verfahren nach einem der vorhergehenden Ansprüche, dadurch gekennzeichnet, daß die Verbindung der lichtundurchlässigen Scheibe (2) und des transparenten Streifens mit Hilfe einer transparenten Wachsschicht verwirklicht wird.

5. Verfahren nach einem der vorhergehenden Ansprüche, dadurch gekennzeichnet, daß die Justier- und Belichtungsvorgänge mit Hilfe in Projektion arbeitender Einflächen-Apparatur verwirklicht werden.

6. Verfahren nach einem der vorhergehenden Ansprüche, dadurch gekennzeichnet, daß das dritte Justiermuster (8) in der Weise symmetrisch ist, daß es bei Klappung sich selbst gleich bleibt und daß die Justiermaske (10) und die Nachjustiermaske (10') identisch sind.
